# EUROPEAN PATENT SPECIFICATION

(11) **EP 0 696 411 B1**
(45) Date of publication and mention of the grant of the patent: **27.12.1996**
(21) Application number: 94913739.2
(22) Date of filing: 29.04.1994
(51) Int. Cl.: H05K 13/04, H01R 17/12

(54) **IMPROVEMENTS RELATING TO COMPONENT MOUNTING ARRANGEMENTS**
VERBESSERUNG FÜR DIE ZUSAMMENBAUEINRICHTUNG VON KOMPONENTE
AMELIORATIONS CONCERNANT DES AGENCEMENTS POUR LE MONTAGE DE COMPOSANTS

(30) Priority: 30.04.1993 GB 9308960
(43) Date of publication of application: 14.02.1996
(73) Proprietor: ITT INDUSTRIES LIMITED, Hampshire RG22 4BW (GB)
(72) Inventor: GRAY, Ian, James, Stafford "Wild Harvest", Hampshire SO21 3AN (GB); BRUMWELL, Peter, John, Portsmouth Hants P06 2PZ (GB)
(74) Representative: Vaufrouard, John Charles
(86) International application number: PCT/GB94/00925
(87) International publication number: WO 94/26085

(56) References cited:
- EP-A- 0 181 305
- US-A- 5 112 249

## Description

This invention relates to coaxial connectors and more particularly to the provision for the secure mounting of such connectors on printed circuit or wiring boards prior to the automatic soldering of the components to such boards.

The present invention is especially, but not exclusively applicable, to the secure mounting of an RF electrical connector on a printed circuit or wiring board prior to the soldering of the terminals of the connector to conductive elements (e.g. tracks) of the printed or wiring board.

Such a connector may comprise an array of metal terminal members projecting orthogonally in parallel from an undersurface of the component body. The terminal members are arranged to extend through appertaining plated-through holes formed in a printed circuit board as the connector is mounted on the board in readiness for subsequent soldering of the component terminal members to conductive tracks on the board contiguous with the plated-through holes.

It is important that the connector is securely mounted on the board during the component assembly procedure to prevent the components from becoming dislodged, or even separated, from the printed board (e.g. as by tilting) before and/or during an automatic soldering process for soldering the components to the printed board.

It has hitherto been proposed to provide the terminal legs of an RF electrical connector with integral barbs or the like which serve to bite into the plating of appertaining plated-through holes in the board, as the terminal legs are pressed therethrough, for the secure mounting of the connector on the board. Such arrangements for securely mounting a connector on the board prior to automatic soldering suffers from the disadvantage that the plating of the plated through-holes may be damaged by the barbs as the connector is pressed down on to the board, particularly in view of the manufacturing tolerances which give rise to variations in the plated hole and/or barb dimensions. Moreover, the barbs make it very difficult to remove the connector from the board without serious damage being caused to the plated through-holes, once a component has been mounted on the board in readiness for soldering, such removal sometimes being necessary due to the mounting of the wrong connector on the board or to the mounting of the connector at an incorrect location on the board.

A coaxial electrical connector is described in European Patent Specification Number 0181305 in which a metal spring clip is provided which fits into a slot in an insulating support and makes contact with the metal housing of the connector. The clip is provided with a pair of legs which each have an outwardly extending ramp portion at its end with a connecting inward extending inclined portion thereafter. The ramp provides for easy insertion in a circuit board while the inclined portion contacts the lower edge of the opening in the circuit board through which the legs are inserted. The connector includes three plain stamped terminals one of which is substantially central. This construction is a complex arrangement and relies on the clip for securement to the board. The present invention seeks to provide a simplified arrangement for securement of a coaxial connector to a circuit board.

In accordance with the present invention there is provided a coaxial connector mountable on a printed circuit or wiring board prior to the soldering of its terminal means to conductive elements (e.g. tracks) on the board contiguous with one or more of a plurality of plated-through holes extending through the board for slidingly receiving respective conductive legs projecting in parallel relationship from an underside of the connector, in which the central conductor terminal means comprises electrical terminal pin or contact extending in parallel relationship with the conductive legs characterised in that the terminal pin or contact is spaced from the conductive legs and is shaped or profiled to permit the terminal pin to be deflected laterally from the normal position thereof as it moves into a further plated-through hole in a printed circuit or wiring board while the conductive legs slidingly engage their respective plated through holes and in which the shaping or profiling of the terminal pin allows the pin to resume, at least substantially, its normal position relative to the conductive legs and thereby co-operates with the printed circuit board to retain the connector securely in position when it becomes fully mounted.

To facilitate deflection of the terminal pin the pin may be offset from the appertaining plated-through hole in the printed board and such offset is preferably achieved by arranging that the plated-through holes for mounting the component are symmetrically arranged whereas the terminal pin is slightly asymmetrically disposed relative to the conductive legs of the component.

In carrying out the present invention the resumption of the terminal pin of the connector to its normal position may occur suddenly as the connector is pressed down, in order to provide a positive snap action.

The deflection of the terminal pin on insertion of the pin into the appertaining plated through-hole may be permitted due to the inherent resilience of the terminal pin itself and/or the inherent resilience of an insulating support member for the terminal pin.

The terminal pin or contact may be profiled by providing it with a cone-shaped enlarged head portion at its free end. In cases where the printed circuit or wiring board is of a standard thickness the rear end of the cone shaped-head portion may present a radially extending annular shoulder a substantial part of which abuts against the under surface of the printed circuit board to hold the connector securely when the pin resumes its normal position after fully mounting of the component on the board.

In cases where the printed circuit board or wiring board is of non-standard thickness the cone-shaped enlarged head portion of the terminal pin may be preceded by an oppositely-tapered conical section which allows the terminal pin to resume substantially its normal non-deflected position once the head of the terminal pin has passed through the appertaining plated-through hole of the printed board.

The present invention is particularly applicable to an RF electrical connector the centrally disposed terminal pin or contact of which having the cone-shaped head portion will be connected or connectible to the central conductor of a coaxial cable while the conductive legs of the connector will be connected to the metal body of the connector connected to the braided sheath of the coaxial cable for grounding purposes.

The RF electrical connector may simply comprise a rectangular (e.g. square) apertured base member from the underside of which four terminal legs defining a square leg array extend in parallel relationship. The apertured base of the connector may have a hollow cylindrical body part extending upwards therefrom for receiving the end of a coaxial cable and embodying a dielectric bush through which extends a central terminal pin or contact for connection at the upper end thereof to the central conductor of the coaxial cable and for insertion at its lower end, provided with a cone-shaped head portion, through a plated hole in the printed circuit board. The axis of this terminal pin or contact is slightly offset from the centre of the square terminal leg array.

In another embodiment of the invention as applied to an RF connector, the base of the connector comprises a rectangular block having a cylindrical aperture therein from the underside of which four terminal legs project in parallel relationship. The block has extending from the base thereof a central terminal pin or contact which is supported in a dielectric bush and provided with a cone-shaped head portion. However, in this case the block has a laterally-extending hollow cylindrical body part the weight of which would tend to cause the connector to tilt when mounted on a printed circuit board without the secure mounting arrangement provided by the present invention by which a deflectable suitably-shaped electrical terminal extends from the block base in parallel with but slightly offset from the centre of the rectangular leg array and connectible with the central conductor of a coaxial cable.

By way of example the present invention will now be described with reference to the accompanying drawings in which:-
Figure 1 shows an enlarged perspective view of one embodiment of an RF electrical connector according to the invention prior to the mounting thereof on a printed circuit board with parts of the connector and printed circuit board being cut away;
Figure 2 is a diagrammatic underneath view of the connector of Figure 1 showing the normal positional relationship between terminals of the connector before and after the mounting thereof on the printed circuit board;
Figure 3 is a perspective view of another embodiment of an RF electrical connector according to the invention prior to the mounting thereof on a printed circuit board; and,
Figure 4 is a diagrammatic underneath view of the connector of Figure 3 showing the normal positional relationship between terminals of the connector before and after the mounting thereof on the printed circuit board.

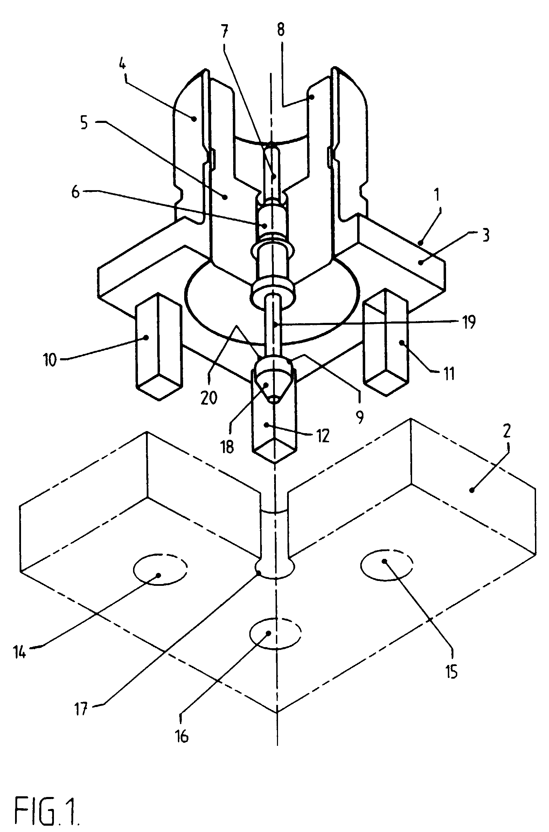

Referring to Figure 1, there is shown an RF electrical connector 1 before the mounting thereof on a printed circuit board 2. The connector comprises an apertured metal body formed by an apertured square base 3 having an integral hollow cylindrical part 4 extending upwards therefrom. The through passageway provided by the apertured connector body accommodates an insulating bush 5 of dielectric material. An electrical pin terminal 6 extends through and is supported by the bush 5. The upper end 7 of the pin terminal 6 which projects into a cavity 8 in the bush 5 will be electrically connected to the central conductor of a coaxial cable (not shown) with the usual external braiding of the cable being electrically connected to the metal body of the connector for grounding purposes.

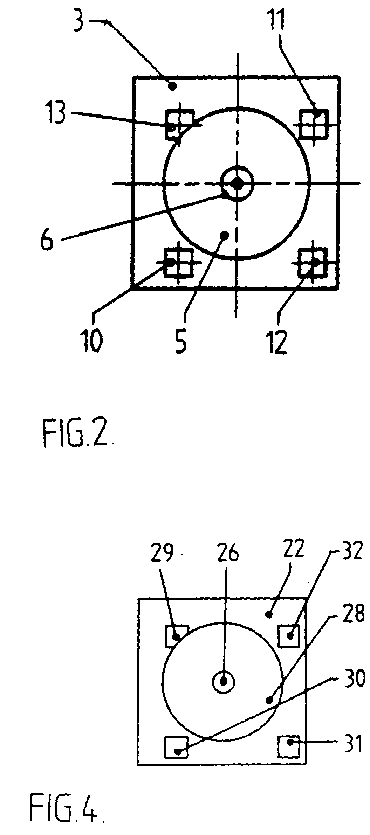

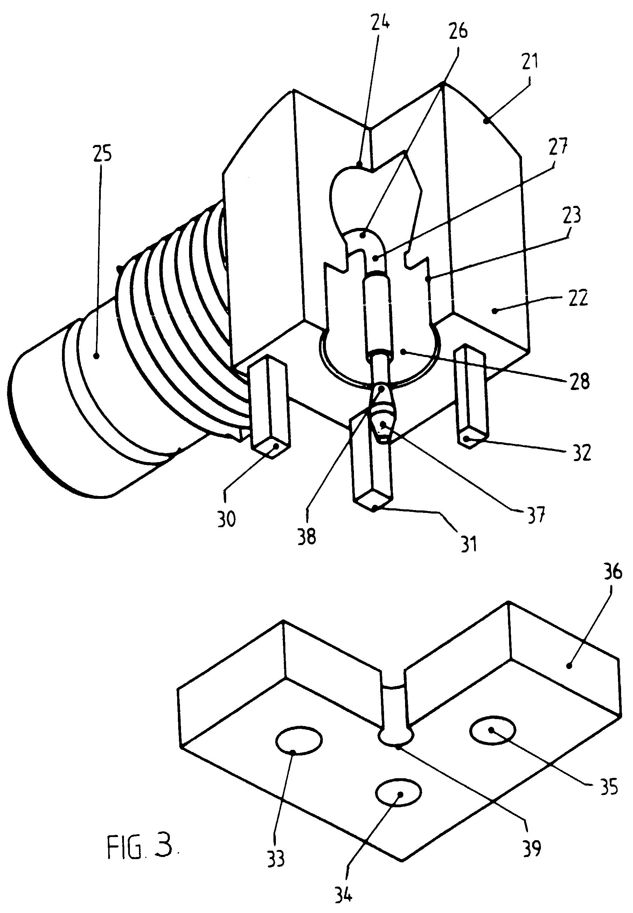

The lower end 9 of the pin terminal 6 projects orthogonally from the underside of the square base 3 of the connector body. The base 3 has four metal terminal legs 10, 11, 12 and 13 defining a square terminal leg array, as can best be seen in Figure 2. These terminal legs are shown as being of square cross section but they may be of any other suitable shape and are positioned and dimensioned to fit slidingly into four plated-through printed circuit board holes, three of which are shown at 14, 15 and 16 in Figure 1. The printed circuit board 2 for mounting the connector 1 also has a plated-through hole 17 located centrally relative to the other four plated-through holes. The hole 17 is for slidingly receiving the lower end 9 of the pin terminal 6 projecting downwardly from the connector body part 3.

In accordance with the invention the axis of the lower projecting end 9 of the terminal pin 6 is offset slightly from the centre of the square leg array, as can clearly be seen in Figure 2. At the same time the projecting end 9 of the terminal pin 6 is provided with a cone-shaped head portion 18 and the pin is deflectable laterally, such as due to the resilience of the dielectric material of the supporting bush 5 and/or the inherent resilience of the terminal pin metal. The part 19 of the terminal pin immediately above or preceding the head portion 18 is of substantially reduced diameter cylindrical configuration so that the head portion 18 presents an upwardly facing annular shoulder 20.

In order to mount the connector 1 on the board 2 the connector will be located relative to the board so that the terminal legs 10, 11, 12 and 13 of the connector are brought into registration with and then enter the appertaining holes in the board as the connector is pressed downwards.

Although the lower projecting end 9 of the terminal pin 6 is offset relative to the centre of the square terminal leg array (see Figure 2) so that the pin axis is also offset from the axis of the plated-through hole 17, the narrow tapered end of the cone-shaped head portion 18 nevertheless enters and moves downwardly into the hole 17 as pressure is applied to the connector body. However, as the cone-shaped head 18 moves progressively down into the hole 17 the projecting end 9 of the terminal pin will be deflected to one side, as permitted by the resilience of the supporting bush 5 and/or the metal of the terminal pin 6, until the head portion 18 moves out of the bottom end of the board hole 17 whereupon the terminal pin end 9 suddenly resumes its original non-deflected position by a lateral snap displacement of the end 9 so that a substantial part of the shoulder 20 engages the undersurface of the printed circuit board 2 and the connector is effectively securely locked to the board. Such locking action or secure mounting of the connector 1 on the board 2 prevents the connector from becoming dislodged or even being separated from the printed circuit board before or during subsequent automatic soldering of the connector terminals to conductive tracks (not shown) on the board contiguous with the plated-through holes.

However, if for any reason it becomes necessary to remove the connector 1 from the board 2 before soldering, the pin terminal end 9 can readily be deflected laterally in order to allow withdrawal of the connector from the board.

Referring now to Figures 3 and 4 of the drawings which illustrate a different embodiment of the invention, in this case a connector 21 comprises a metal body formed by a rectangular block structure 22 provided with internal generally cylindrical cavities 23 and 24 located at right-angles to one another. The cavity 24 is effectively extended by a cylindrical cavity (not shown) in a laterally extending hollow cylindrical metal body part 25. The connector embodies a generally centrally disposed terminal pin 26 which has a downwardly extending portion 27 which is insulatingly supported within the metal block structure 22 of the connector by means of an insulating bush 28 of dielectric material. The connector has four terminal legs 29, 30, 31 and 32 which are shown as being of square cross section, as can best be seen in Figure 4. These terminal legs which could be of any other suitable cross-sectional shape project downwardly from the base 22 in parallel relationship and define a square terminal leg array. The terminal legs are designed to be slidingly received by respective appertaining plated-through holes, three of which are shown at 33, 34 and 35, in a printed circuit board 36.

As will readily be appreciated, the connector 22, unlike the connector 1 of Figures 1 and 2, is of asymmetrical configuration as a consequence of which the connector would have a considerably greater tendency to tilt to cause partial withdrawal or dislodgement of at least two of the terminal legs from their respective holes in the printed circuit board 36 when the connector is mounted on the board prior to and/or during automatic soldering of the board, unless the connector mounting is secure.

In accordance with the invention the terminal pin 26 is provided at its lower end with a cone-shaped head portion 37 similar to that of the Figure 1 embodiment. However, in the case of the present embodiment an oppositely tapered conical section 38 is provided immediately above or preceding the cone-shaped head portion 37. This allows for variations in the thickness of the printed circuit board 36, as hereinafter will be apparent.

To mount the connector 21 on the printed circuit board 36 which also has a centrally-disposed plated-through hole 39 for receiving the terminal pin 26, the terminal legs, as in the case of Figure 1, are moved into registration with their appertaining plated-through holes. Pressure is then applied to the connector so that the lowermost narrow-tapered end of the cone-shaped head portion 37 enters the hole 39. Due to the pin 26 being offset from the centre of the terminal leg square array, as can be seen in Figure 4, the lower projecting end of the pin 26 will then be deflected to one side against the resilience of the pin metal and/or the resilience of the material of the bush 28 as the cone-shaped head portion 37 travels down through the hole 39.

After the cone-shaped head portion 37 emerges from the bottom of the painted through-hole 39, the oppositely tapered portion 38 allows the laterally deflected projecting terminal pin end to restore progressively towards its original position as the pin end moves further through the hole 39. As will be appreciated, the restoration of the terminal pin end in the case of this embodiment will not be as positive in providing the snap action mounting of the connector on the printed circuit board as in the Figure 1 embodiment, but the oppositely tapered section 38 does facilitate the use of the secure mounting arrangement of the invention with printed circuit or wiring boards of varying thicknesses.

## Claims

1. A coaxial connector (1) mountable on a printed circuit or wiring board (2) prior to the soldering of its terminal means (6) to conductive elements e.g. tracks on the board contiguous with one or more of a plurality of plated-through holes (14,15,16) extending through the board for slidingly receiving respective conductive legs (10,11,12) projecting in parallel relationship from an underside of the connector, in which the central conductor terminal means comprises electrical terminal pin or contact (6) extending in parallel relationship with the conductive legs characterised in that the terminal pin or contact (6) is spaced from the conductive legs (14,15,16) and is shaped or profiled to permit the terminal pin to be deflected laterally from the normal position thereof as it moves into a further plated-through hole (17) in a printed circuit or wiring board while the conductive legs (10,11,12) slidingly engage their respective plated through holes (14,15,16) and in which the shaping or profiling of the terminal pin (6) allows the pin to resume, at least substantially, its normal position relative to the conductive legs (10,11,12) and thereby co-operates with the printed circuit board (2) to retain the connector securely in position when it becomes fully mounted.

2. A coaxial connector as claimed in claim 1, in which the deflection of the terminal pin or contact (6) during insertion of the pin into its appertaining plated-through hole (17) is facilitated by the axis of the terminal pin being offset slightly from the centre of a symmetrical array of conductive legs (10,11,12) for cooperation with a plated through hole (17) in the printed circuit board (2) for receiving the terminal pin which is centrally disposed relative to an array of plated-through holes (14,15,16) for receiving the conductive legs.

3. A coaxial connector as claimed in claim 1 or claim 2, wherein the terminal pin (6) is deflectable due to the resilience of the pin metal and/or of the insulating material of a pin support member (5).

4. A coaxial connector as claimed in any preceding claim, in which the terminal pin (6) is so shaped and dimensioned that the terminal pin resumes its normal non-deflected position suddenly to provide a positive snap action as the connector becomes fully mounted on a board.

5. A coaxial connector as claimed in any preceding claim, in which the terminal pin (6) is provided at the lower end thereof with an enlarged cone-shaped head portion (18) which is cooperable with an appertaining plated-through hole (17) to produce deflection of the pin as it enters the hole.

6. A coaxial connector as claimed in claim 5 as dependant on claim 3, in which the enlarged cone -shaped head portion (18) presents to the rear thereof a radially-extending annular shoulder (20) for abutment against the undersurface of a printed circuit board (2) to lock the connector (1) to the board when the connector becomes fully mounted on the board by snap action.

7. A coaxial connector as claimed in claim 5 as dependant on any of claims 1 to 3, in which the enlarged cone-shaped head portion (18) has an oppositely tapered cone section (38) immediately rearwards of it, the oppositely tapered cone section allowing the terminal pin (6) to resume, at least substantially, its normal position after the head portion emerges from an appertaining plated through hole (39), irrespective of variations in thickness of the printed circuit board (36).

8. A coaxial connector as claimed in any preceding claim, in which the connector (1) comprises a body with a rectangular (e.g. square) apertured metal base structure (3) from which projects a rectangular array of conductive legs (10,11,12) in parallel relationship and in which the central terminal or contact (6) of the connector which is supported by an insulating bush (5) of dielectric material projects from the base in parallel with the conductive legs but the axis thereof is offset from the centre of the leg array.

9. A coaxial connector as claimed in claim 8, in which the body of the connector is symmetrical.

10. A coaxial connector as claimed in claim 8, in which the body of the connector has a part (25) thereof which extending laterally from the base structure to define an asymmetrical connector body.

11. A coaxial connector as claimed in any preceding claim in combination with a printed circuit board (2) provided with an arrangement of plated through holes (17,14,15,16) for receiving the terminal pin (6) and conductive legs (10,11,12).

## Patentansprüche

1. Eine Koaxialstecker (1), der auf eine Platine oder eine Verdrahtungsplatte (2) montiert wird, bevor seine Anschlußstelle (6) an leitenden Elemente, z.B. Leiterbahnen auf der Platine angelötet werden, angrenzend an ein oder mehrere durchmetallisierte Löcher (14, 15, 16), die sich über die Platine erstrecken, um entsprechende leitende Schenkel (10, 11, 12) gleitend aufzunehmen, die parallel zueinander von der Unterseite des Steckers hervorragen, wobei der Mittelleiteranschluß einen elektrischen Anschlußstift oder - kontakt (6) umfaßt, der sich parallel der leitenden Schenkel erstreckt, dadurch gekennzeichnet,
daß der elektrische Anschlußstift oder - kontakt (6) mit einem Abstand von den leitenden Schenkeln (14, 15, 16) versehen ist und so geformt bzw. profiliert ist, daß der Anschlußstift quer von seiner Normalstellung gebogen werden kann, während er in ein weiteres durchmetallisiertes Loch (17) in einer Platine oder Verdrahtungsplatte eindringt, während die leitenden Schenkel (10, 11, 12) gleitend in deren jeweilige durchmetallisierten Löcher (14, 15, 16) greifen, und wobei die Formung oder Profilierung des Anschlußstiftes (6) dem Stift erlaubt, zumindest wesentlich seine Normalstellung im Verhältnis zu den leitenden Schenkeln (10, 11, 12) wieder einzunehmen, und wobei der Stift damit mit der Platine (2) dahingehend zusammenwirkt, daß er den Stecker sicher festhält, wenn dieser vollständig montiert ist.

2. Ein Koaxialstecker nach Anspruch 1, wobei die Biegung des Anschlußstiftes oder -kontaktes (6) während dem Einsetzen des Stiftes in sein zugehöriges durchmetallisiertes Loch (17) dadurch vereinfacht ist, daß die Achse des Anschlußstiftes leicht von der Mitte einer symmetrischen Anordnung von leitenden Schenkeln (10, 11, 12) versetzt ist, um mit dem durchmetallisierten Loch (17) in der Platine (2) zusammenzuwirken, das den Anschlußstift aufnimmt, welcher im Verhältnis von durchmetallisierten Löchern (14, 15, 16) für die Aufnahme der leitenden Schenkel mittig liegt.

3. Ein Koaxialstecker nach Anspruch 1 oder 2, wobei der Anschlußstift (6) wegen der Elastizität des Stiftmaterials und/oder des Isoliermaterials eines Stützelementes (5) biegbar ist.

4. Ein Koaxialstecker nach einem der vorhergehenden Ansprüchen, wobei der Anschlußstift (6) so geformt und bemaßt ist, daß er seine normale, ungebogene Stellung sofort wieder einnimmt, um ein Einschnappen zu ermöglichen, wenn der Stecker vollständig auf der Platine montiert wird.

5. Ein Koaxialstecker nach einem der vorhergehenden Ansprüchen, wobei der Anschlußstift (6) an seinem unteren Ende einen vergrößerten zapfenförmigen Kopfbereich (18) hat, der mit einem zugehörigen durchmetallisierten Loch (17) so zusammenwirkt, daß bei seinem Eindringen in das Loch eine Biegung des Stiftes erfolgt.

6. Ein Koaxialstecker nach Anspruch 5 in Abhängigkeit von Anspruch 3, wobei der vergrößerte zapfenförmigen Kopfbereich (18) an seinem hinteren Teil einen radial verlaufenden ringförmigen Vorsprung (20) hat, der gegen die Unterseite der Platine (2) angrenzt, um den Stecker (1) mit der Platine zu verhaken, wenn der Stecker durch Einschnappen fest mit der Platine montiert wird.

7. Ein Koaxialstecker nach Anspruch 5 in Abhängigkeit von einem Anspruch 1 bis 3, wobei der vergrößerte zapfenförmige Kopfbereich (18) eine auf der gegenüberliegenden Seite konisch zulaufenden zapfenförmigen Abschnitt (38) hat, der direkt von ihm nach hinten verläuft, wobei der gegenüberliegende konisch zulaufende zapfenförmige Abschnitt dem Anschlußstift (6) ermöglicht, zumindest im wesentlichen seine Normalstellung wieder einzunehmen, wenn der Kopfbereich aus dem zugehörigen durchmetallisierten Loch (39) wieder auftaucht, dies ungeachtet der Schwankungen in der Stärke der Platine (36).

8. Ein Koaxialstecker nach einem der vorhergehenden Ansprüchen, wobei der Stecker (1) einen Körper mit einer rechteckigen (z.B. quadratischen), mit einer Öffnung versehenen Unterkonstruktion (3) aus Metall umfaßt, aus der eine rechteckige Anordnung von parallel liegenden leitenden Schenkeln (10, 11, 12) herausragt, wobei der mittlere Anschluß oder Kontakt (6) des Steckers, der von einer Isoliertülle (5) aus dielektrischem Material gestützt wird, aus der Unterplatte parallel mit den leitenden Schenkeln herausragt, dessen Achse jedoch von der Mitte der Schenkelanordnung versetzt ist.

9. Ein Koaxialstecker nach Anspruch 8, wobei der Steckerkörper symmetrisch ist.

10. Ein Koaxialstecker nach Anspruch 8, wobei der Steckerkörper ein Teil (25) besitzt, das quer von der Unterkonstruktion verläuft, um einen asymmetrischen Steckerkörper zu definieren.

11. Ein Koaxialstecker nach einem der vorhergehenden Ansprüchen in Verbindung mit einer Platine (2), die eine Anordnung von durchmetallisierten Löchern (17, 14, 15, 16) hat, um den Anschlußstift (6) und die leitenden Schenkel (10, 11, 12) aufzunehmen.

## Revendications

1. Connecteur coaxial (1) pouvant être monté sur un panneau de circuits imprimés ou un panneau de câblage (2) avant le soudage de ses moyens formant borne (6) à des éléments conducteurs, par exemple des pistes sur le panneau contiguës à un ou plusieurs trous parmi une pluralité de trous traversants plaqués (14,15,16) qui traversent le panneau de manière à loger, avec possibilité de glissement, des bras conducteurs respectifs (10,11,12) qui font saillie, selon une disposition en parallèle, à partir d'une face inférieure du connecteur, et dans lequel les moyens formant borne du conducteur central comprennent une broche ou un contact de borne électrique (6) qui s'étend parallèlement aux bras conducteurs, caractérisé en ce que la broche ou le contact de borne (6) est distant des bras conducteurs (14,15,16) et est conformé ou profilé de manière à permettre une déviation latérale de la broche de borne par rapport à sa position normale lorsqu'elle pénètre dans un autre trou traversant plaque (17) situé dans un panneau à circuits imprimés ou un panneau de câblage tandis que les bras conducteurs (10,11,12) s'engagent avec possibilité de glissement dans les trous traversants plaqués respectifs (14,15,16), qui leur sont associés, et dans lequel la conformation ou le profil de la broche de borne (6) permet à la broche de revenir, au moins pour l'essentiel, dans sa position normale par rapport aux bras conducteurs (10,11,12) et coopère de ce fait avec le panneau de circuits imprimés (2) pour maintenir le connecteur fermement en position lorsqu'il est à l'état complètement monté.

2. Connecteur coaxial selon la revendication 1, dans lequel la déviation de la broche ou du contact de borne (6) pendant l'insertion de la broche dans le trou traversant plaqué (17), qui lui est associé, est facilitée par le fait que l'axe de la broche de borne est légèrement décalé par rapport au centre d'un réseau symétrique de bras conducteurs (10,11,12) pour coopérer avec un trou traversant plaqué (17) ménagé dans le panneau de circuits imprimés (2) pour recevoir la broche de borne, qui est disposée en position centrale par rapport à un réseau de trous traversants plaqués (14,15,16) servant à recevoir les bras conducteurs.

3. Connecteur coaxial selon la revendication 1 ou 2, dans lequel la broche de borne (6) peut être déviée sous l'effet de la résilience du métal de la broche et/ou du matériau isolant d'un élément (5) de support de la broche.

4. Connecteur coaxial selon l'une quelconque des revendications précédentes, dans lequel la broche de borne (6) est conformée et dimensionnée de telle sorte que la borne de broche reprend brusquement sa position normale non déviée pour produire une action d'encliquetage positif lorsque le connecteur est complètement monté sur un panneau.

5. Connecteur coaxial selon l'une quelconque des revendications précédentes, dans lequel la broche de borne (6) comporte, sur son extrémité inférieure, une partie de tête élargie de forme conique (18), qui peut coopérer avec un trou traversant plaqué associé (17) pour provoquer une déviation de la broche lorsqu'elle pénètre dans le trou.

6. Connecteur coaxial selon la revendication 5, considérée comme dépendante de la revendication 3, dans lequel la partie de tête élargie de forme conique (18) comporte, sur son côté arrière, un épaulement annulaire (20) qui s'étend radialement et est destiné à venir en butée contre la surface inférieure d'un panneau de circuits imprimés (2) pour bloquer le connecteur (1) sur le panneau lorsque le connecteur est entièrement monté sur le panneau sous l'effet d'une action d'encliquetage.

7. Connecteur coaxial selon la revendication 5, considérée comme dépendante de l'une quelconque des revendications 1 à 3, dans lequel la partie de tête élargie de forme conique (18) possède une section conique (38), qui se rétrécit en sens opposé et qui est située directement en arrière de cette partie de tête, la section conique, qui se rétrécit en sens opposé, permettant à la broche de borne (6) de reprendre, au moins pour l'essentiel, sa position normale après que la partie de tête soit sortie d'un trou traversant plaqué associé (39), indépendamment de variations de l'épaisseur du panneau de circuits imprimés (36).

8. Connecteur coaxial selon l'une quelconque des revendications précédentes, dans lequel le connecteur (1) comprend un corps possédant une structure de base métallique ajourée rectangulaire (par exemple carrée) (3), d'où fait saillie un ensemble rectangulaire de broches conductrices (10,11,12) disposées parallèlement et dans lequel la borne ou le contact central (6) du connecteur, qui est supporté par un manchon isolant (5) en matériau diélectrique, fait saillie à partir de la base parallèlement aux bras conducteurs, mais dont l'axe est décalé par rapport au centre du réseau de bras.

9. Connecteur coaxial selon la revendication 8, dans lequel le corps du connecteur est symétrique.

10. Connecteur coaxial selon la revendication 8, dans lequel le corps du connecteur comporte une partie (25) qui s'étend latéralement à partir de la structure de base pour définir un corps de connecteur dissymétrique.

11. Connecteur coaxial selon l'une quelconque des revendications précédentes en combinaison avec un panneau de circuits imprimés (2) pourvu d'un ensemble de trous traversants plaqués (17,14,15,16) pour recevoir la broche de borne (6) et les bras conducteurs (10,11,12).
